# EUROPEAN PATENT SPECIFICATION

(11) **EP 1 391 906 B1**
(45) Date of publication and mention of the grant of the patent: **26.10.2011**
(21) Application number: 03254975.0
(22) Date of filing: 11.08.2003
(51) Int. Cl.: H01H 59/00, H01H 57/00, H01P 1/12

(54) **Electrostatic RF mems switches**
Mikroelektromechanische elektrostatische RF Schalter
Interrupteurs rf, électrostatiques et microeléctromecaniques

(30) Priority: 20.08.2002 KR 2002049319
(43) Date of publication of application: 25.02.2004
(73) Proprietor: Samsung Electronics Co., Ltd., Gyunggi-do (KR)
(72) Inventor: Song, In-sang, Gwanak-gu, Seoul (KR); Lee, Moon-chul, Sungnam-city, Gyunggi-do (KR); Kim, Young-il, Jangan-gu, Suwon-city, Gyunggi-do (KR); Shim, Dong-ha, Seocho-gu, Seoul (KR); Hong, Young-tack, Suwon-city, Gyunggi-do (KR); Park, Sun-hee, Gwanak-gu, Seoul (KR); Nam, Kuang-woo, Yongin-city, Gyunggi-do (KR)
(74) Representative: Ertl, Nicholas Justin

(56) References cited:
- EP-A- 0 923 099
- WO-A-01/57901
- WO-A-94/18688
- DE-A1- 4 305 033
- US-B1- 6 426 687

## Description

The present invention relates to micro switches. More particularly, the present invention relates to Radio Frequency Micro-Electro Mechanical Systems (RF MEMS) micro switches, which use an electrostatic force for driving thereof.

In general, frequency separators (F/S's), field effect transistors (FETs), PIN diode switches, and so on, for high-frequency signal switches are used to control electric signals, e.g., for closing, restoring, and switching electric circuits in electronic systems.

However, drawbacks associated with the devices above include a low frequency separation degree in the F/S and a high insertion loss, low isolation, high power consumption, etc., in the semiconductor switches. Currently, micro switches for high frequency signals are used to make up for such drawbacks. Micro switches for high-frequency signals are classified into resistively coupled (RC) switches and capacitively coupled (CC) switches based on a switching coupling method.

The micro switches are further classified into a cantilever type and a bridge type based on structural features of hinge parts thereof. The micro switches are also classified into a shunt-type and a series-type based on a high frequency signal switching method.

The operation principle of micro switches is to actuate hinge parts of a micro switch structure using electrostatic force, magnetostatic force, oscillation of piezoelectric element, and the like, as energy sources to turn signal terminal contact portions on and off. The micro switches are also classified into an electrostatic actuation type and a piezoelectric actuation type based on a driving method.

The conventional shunt-type micro switch described above has a structure in which signal terminates simultaneously play an electrode role of generating electrostatic forces, and input signal terminals and output signal terminals are connected to each other when the switch is in an off-state. Further, when the switch is in an on-state, a signal terminal and a ground terminal are short-circuited so that the output of an input signal is cut off. The shunt-type micro switch has a simple structure, but the switch suffers from a low isolation degree and on/off ratio.

The conventional series-type micro switch described above is a relay switch that completely separates input and output signal terminals from upper and lower electrodes generating an electrostatic force, in which, when the switch is in an off-state, the input and output signal terminals are completely disconnected so that an output for an input signal is cut off. Further, when the switch is in an on-state, the input and output signal terminals are connected so that an input signal is outputted. The series-type micro switch has a high isolation degree and on/off ratio, but drawbacks of the switch include a complex structure, a very difficult process, and a structure that is easily deformed.

EP 0 923099 discloses a micro relay which uses a piezoelectric element to curve a movable piece to bring a movable contact in and out of contact with a pair of fixed contacts.

According to the invention, there is provided a micro switch as claimed in claim 1.

Preferably, a portion of the substrate positioned under the movement region, a portion of the dielectric layer surrounding the movement region except where the hinge part is formed, and a portion of the substrate positioned under a portion of the dielectric layer surrounding the movement region, are selectively etched to provide an etched region for allowing the movement region to move up and down.

The piezoelectric layer is preferably formed between the conductive layer and the hinge part, and anchors respectively supporting the electric conductors, signal terminals applying signals to the electric conductors, and piezoelectric electrode terminals applying a voltage to the piezoelectric layer may also be included.

The invention provides a series-type micro switch which has a high on/off ratio and isolation degree, a simple structure, and can be easily fabricated in a very simple process.

Any of the conductive layer, the electric conductors, the lower electrode(s), the upper electrode(s), the anchor(s), the signal terminal(s) and the piezoelectric electrode terminal(s) is formed of one, or a combination of more than one selected from the group consisting of Au, Ag, Cu, Pt and Rd.

The above and other features and advantages of the present invention will become more apparent to those of ordinary skill in the art by describing in detail preferred embodiments thereof with reference to the attached drawings in which:
FIG. 1 illustrates a plan view for showing a micro switch;
FIG. 2 illustrates a first side cross-sectional view for showing the off-state of the micro switch of FIG. 1;
FIG. 3 illustrates a first side cross-sectional view for showing the on-state of the micro switch of FIG. 1;
FIG. 4 illustrates a second side cross-sectional view for showing the off-state of the micro switch of FIG. 1;
FIG. 5 illustrates a second side cross-sectional view for showing the on-state of the micro switch of FIG. 1;
FIG. 6 illustrates a perspective view for showing the micro switch of FIG. 1;
FIG. 7A to FIG. 7E illustrate views for showing a process for forming a micro switch
FIG. 8 illustrates a perspective view for showing another micro switch; and
FIG. 9 illustrates a perspective view for showing a micro switch according to the present invention.

Hereinafter, preferred embodiments of the present invention will be described with reference to the accompanying drawings.

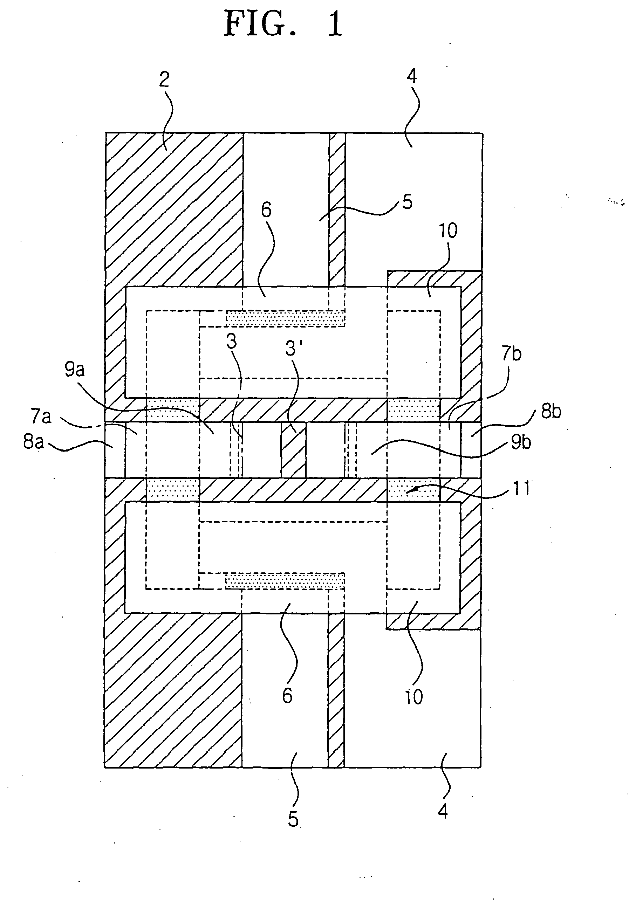

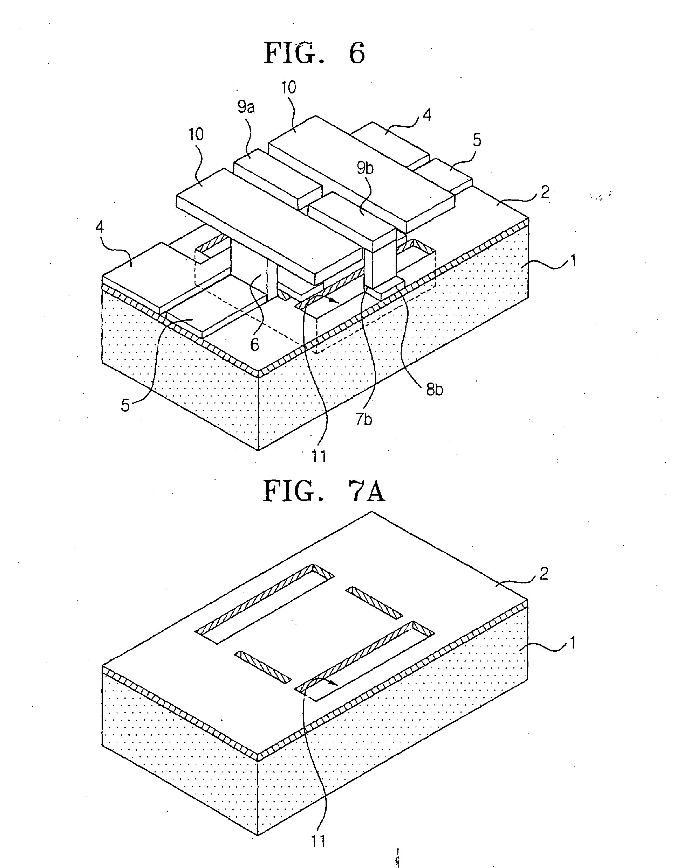

FIG. 1 illustrates a plan view for showing a first example of micro switch, and FIG. 6 illustrates a perspective view for showing the micro switch of FIG. 1.

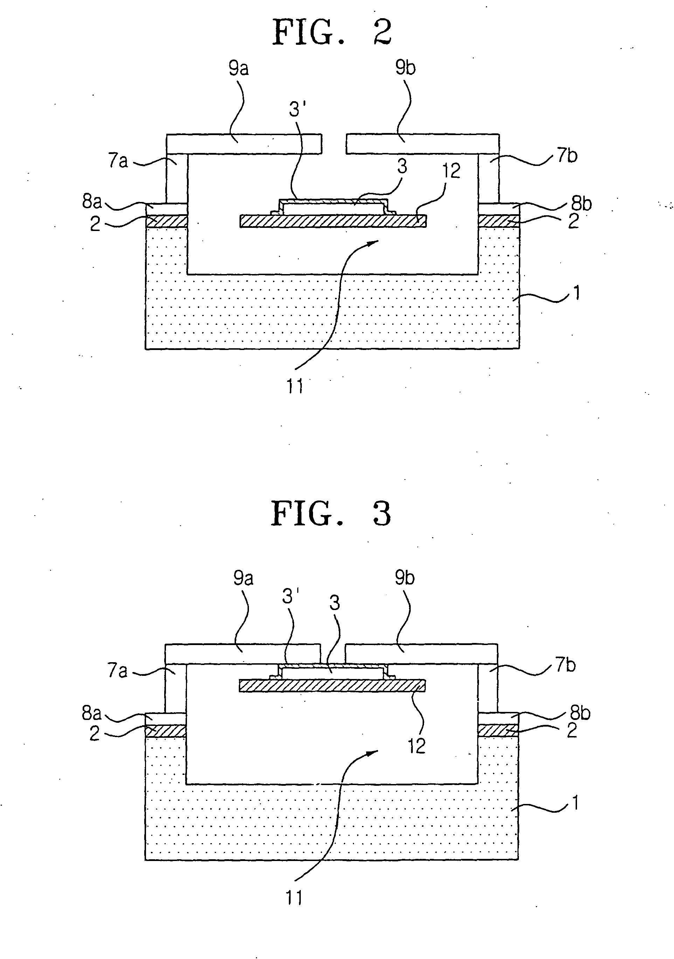

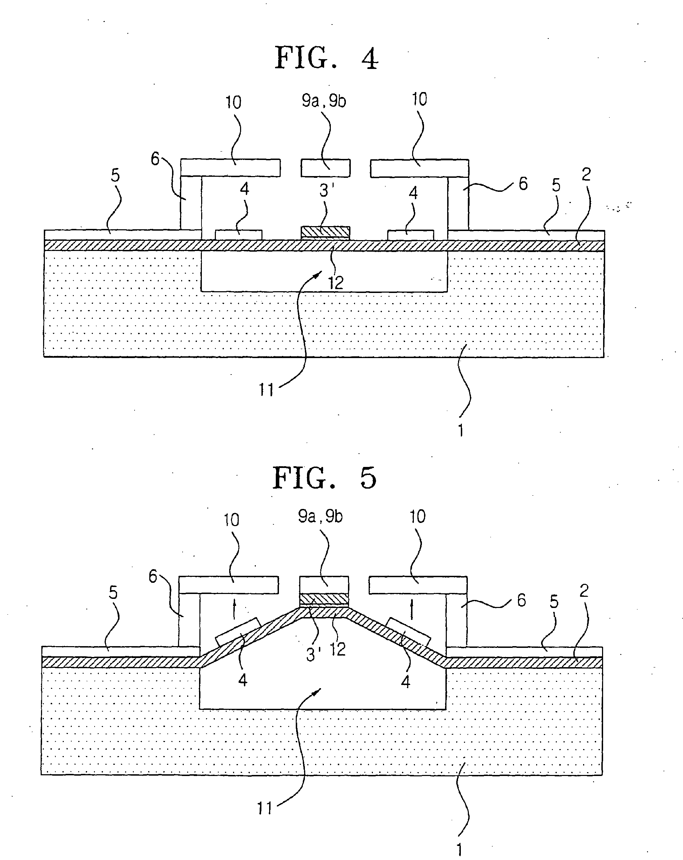

Further, FIG. 2 and FIG. 4 illustrate cross-sectional views showing sides perpendicular to each other when the micro switch of FIG. 1 is in the off-state, and FIG. 3 and FIG. 5 illustrate cross-sectional views showing sides perpendicular to each other when the micro switch of FIG. 1 is in the on-state.

As shown in FIGS. 1 to 5, the micro switch according to a first embodiment of the present invention is a bridge-type electrostatic switch of a capacitively coupled structure.

A dielectric layer 2 is formed on a substrate 1. Either side of a central portion of the dielectric layer 2 are etched to form an etched region 11. The etched region 11 on either side of the central portion of the dielectric layer 2 is mutually communicated underneath the central portion of the dielectric layer 2, as shown in FIG. 2. A portion of the substrate 1 positioned under the central portion of the dielectric layer 2 is selectively etched to expand the etched region 11, as shown in FIGS. 4 and 5. The central portion of the dielectric layer 2 forms a movement region 12, which is capable of easily moving up and down due to the etched region 11 thereunder and on either side thereof. A portion of the dielectric layer 2 forming a hinge portion is etched to allow smooth upward and downward movement in the movement region 12.

A conductive layer 3 is formed on a predetermined central portion of the surface of the movement region 12 of the dielectric layer 2, and a dielectric film 3' is formed on the surface of the conductive layer 3.

First and second electric conductors 9a and 9b are separately disposed a predetermined distance above the conductive layer 3. The first and second electric conductors 9a and 9b are spaced apart from each other, but are mutually connected by the dielectric film 3' when the conductive layer 3 moves upwards.

In the meantime, as shown in FIGS. 4 and 5, lower electrodes 4 are respectively disposed at either end of the movement region 12 of the dielectric layer 2, between hinges formed on either side of the movement region 12 and the conductive layer 3.

Further, as shown in FIGS. 4 and 5, upper electrodes 10 are respectively disposed at positions spaced a predetermined distance over the lower electrodes 4, so an electrostatic force is generated if a predetermined dc voltage is applied between the lower electrodes 4 and the upper electrodes 10, causing the lower electrodes 4 to move toward the upper electrodes 10.

As shown in FIG. 2, the first and second electric conductors 9a and 9b are respectively supported by anchors 7a and 7b.

Further, as shown in FIGS. 4 and 5, the upper electrodes 10 are supported by upper electrode anchors 6, and the upper electrode anchors 6 are connected to upper electrode terminals 5.

As shown in FIGS. 3 and 5, in the micro switch having the above structure, if the lower electrodes 4 fixed at either side of the movement region 12 moves upwards by an electrostatic force generated between the lower electrodes 4 and the upper electrodes 10, the dielectric film 3' at the central portion of the movement region 12 becomes connected to the first and second electric conductors 9a and 9b. At this time, capacitance between the conductive layer 3 and the first and second electric conductors 9a and 9b increases so that an electric signal between the first and second electric conductors 9a and 9b flows.

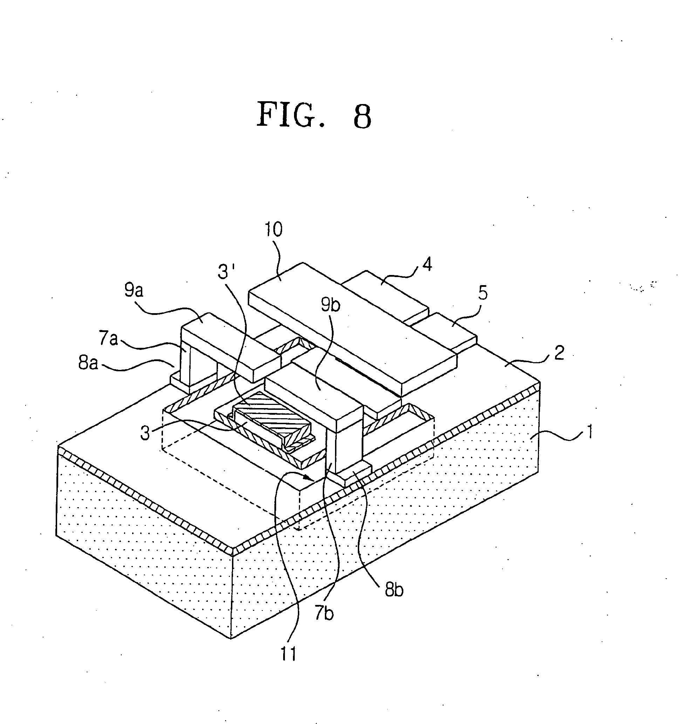

A second example of micro switch is a cantilever switch of a capacitively coupled structure, which will be described with reference to FIG. 8.

As shown in FIG. 8, the second example of electrostatic cantilever switch of a capacitively coupled structure has a single lower electrode 4, a single upper electrode 10, and a single upper electrode terminal 5 formed only at one end of the movement region 12, to one side of a conductive layer 3. There is also not shown in FIG. 8 a single upper electrode anchor disposed between the upper electrode terminal 5 and the upper electrode 10 for supporting the upper electrode 10, which corresponds to one of the upper electrode anchors 6 of the first example illustrated in FIGS. 4 and 5. The lower electrode 4, upper electrode 10, upper electrode anchor and upper electrode terminal 5, which are disposed at only one side of the conductive layer 3 in the second embodiment, were disposed at either side of the conductive layer 3 in the first example.

Further, a hinge part is formed at the side of the conductive layer 3 opposite the side at which the lower electrode 4, upper electrode 10, upper electrode anchor and upper electrode terminal 5 are formed, thereby allowing the lower electrode 4 to move upwards with respect to the hinge part.

The remaining elements and operations of the micro switch having the structure of the second example are the same as those of the first example.

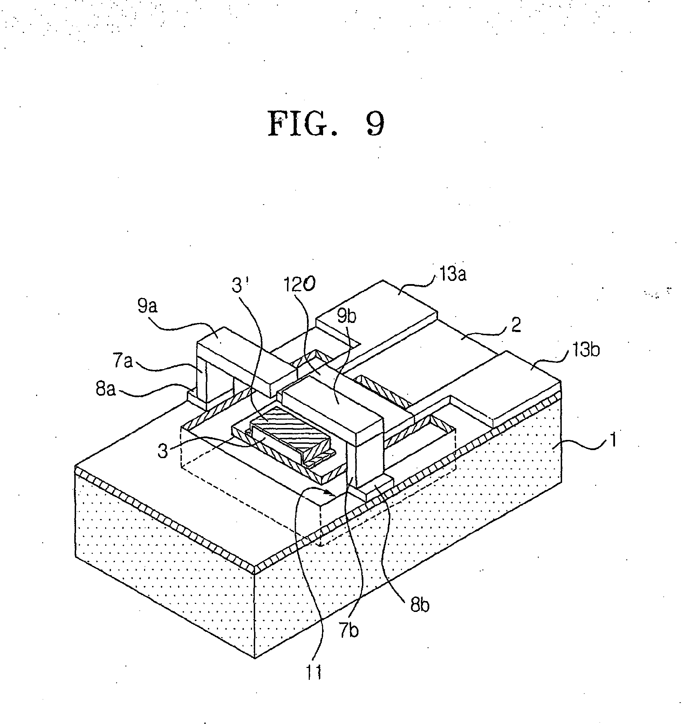

A micro switch according to a first embodiment of the present invention is a piezoelectric cantilever switch of a capacitively coupled structure, which will be described with reference to FIG. 9.

As shown in FIG. 9, the piezoelectric cantilever switch of a capacitively coupled structure according to the present invention has the structure that can be obtained when the upper electrode 10, the lower electrode 4, the upper electrode anchors 6 and the upper electrode terminals 5 are removed from the structure appearing in the structure according to the second example, while a piezoelectric film 120 is formed instead of the lower electrode 4, and piezoelectric electrode terminals 13a, 13b are formed to the piezoelectric layer 120 to apply voltage to the piezoelectric layer 120.

In the micro switch as shown in FIG. 9 according to the the present invention, as a predetermined voltage is applied through the piezoelectric electrode terminals 13a, 13b to the piezoelectric layer 120 fixed between the hinge of the movement region 12 and the conductive layer 3, the dielectric film 3' moves upward to contact with the first electric conductor 9a and the second electric conductor 9b. Accordingly, capacitance between the conductive layer 3 and the first and the second electric conductors 9a, 9b increases, and electric signals flow between the first and the second electric conductors 9a, 9b.

A third example of a micro switch is a bridge-type switch of a resistively coupled structure, which has a structure that the dielectric film 3' is removed from the upper surface of the conductive layer 3 appearing in the structure according to the first example.

In the micro switch having the structure of this third example, the conductive layer 3 at the central portion of the movement region 12 becomes connected to the first and second electric conductors 9a and 9b if the lower electrodes 4 fixed at either end of the movement region 12 move upwards by an electrostatic force between the lower electrodes 4 and the upper electrodes 10. At this time, electric resistance between the conductive layer 3 and the first and second electric conductors 9a and 9b is reduced, so an electric signal between the first and second electric conductors 9a and 9b flows.

The second embodiment of a micro switch according to the present invention is a piezoelectric cantilever switch of a resistively coupled structure, having a structure that the dielectric film 3' is removed from the structure of the above first embodiment of the present invention.

Operations of the micro switch having the structure of the second embodiment as described above are the same as those of the first embodiment of the present invention.

A process for the micro switch according to the first example will now be described with reference to FIGS. 7A to 7E.

As shown in FIG. 7A, a dielectric layer 2 is formed on an upper surface of the substrate 1. FIG. 7A shows etched regions 11 to aid in understanding a three dimensional structure of the micro switch, but the etched regions 11 are formed at a final step of the process, at which time a central portion of the dielectric layer 2 has a densely formed plurality of via holes (not shown) formed therein.

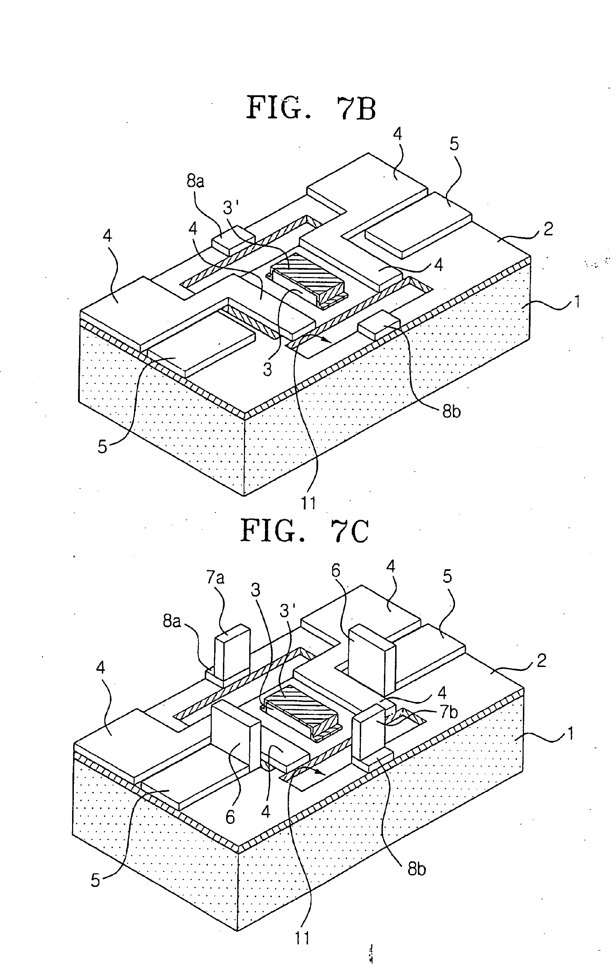

As shown in FIG. 7B, a conductive layer 3 is formed on the central portion of the dielectric layer 2, and a dielectric film 3' is formed on the conductive layer 3. The conductive layer 3 may be formed of one, or a proper combination of Au, Ag, Cu, Pt and Rd, which have excellent electric conductivities.

Further, electrode terminals 5, lower electrodes 4 and signal terminals 8a, 8b are formed opposite each other on the dielectric layer 2 at either side of the conductive layer 3.

Then, as shown in FIG. 7C, patterns are formed for anchors 7a and 7b for respectively supporting first and second electric conductors and for upper electrode anchors 6.

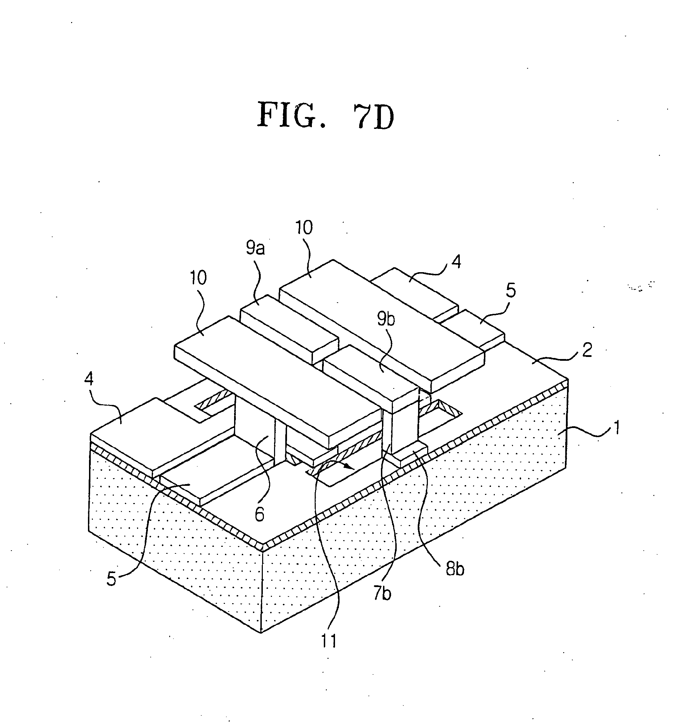

Subsequently, as shown in FIG. 7D, patterns are formed for first electric conductor 9a, second electric conductor 9b, and upper electrode 10.

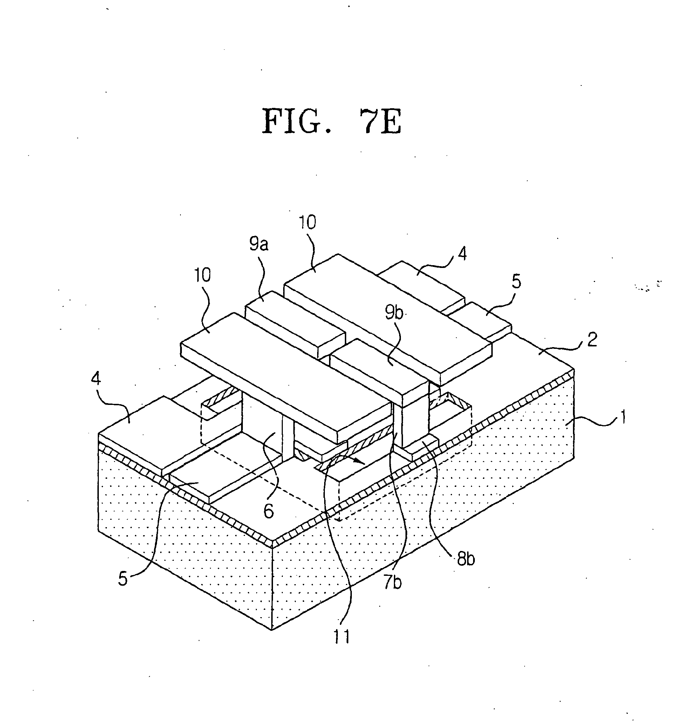

At the final step, as shown in FIG. 7E, the etched regions 11 are formed by a dry etching method in which the plurality of via holes are densely formed in the central portion of the dielectric layer 2. At this time, the etched regions 11 are connected to each other underneath the central portion of the dielectric layer 2.

In the above embodiment, the upper electrode 10 has a rectangular shape, as shown in FIGS. 7D and 7E, and the upper electrode anchors 6 for supporting the upper electrodes 10 are positioned at outer ends of the upper electrodes 10, as shown in FIGS. 4 and 5. However, the shape of the upper electrodes 10 may be diversely transformed, and the positions of the upper electrode anchors 6 for supporting the upper electrodes 10 may be changed.

The micro switch according to the present invention has a simple structure, as well as a high on/off ratio and isolation degree, and may be fabricated in a very easy process.

Preferred embodiments of the present invention have been disclosed herein and, although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. A micro switch, comprising:
a substrate (1);
a dielectric layer (2) formed on the substrate, the dielectric layer having a movement region (12) formed of a predetermined portion of the dielectric layer that is capable of moving up and down;
a conductive layer (3) formed on a predetermined portion of the movement region;
first and second electric conductors (9a,9b) formed above the conductive layer (3); and
a piezoelectric layer (120) formed on the movement region, causing the conductive layer (3) to move upwards by the supply of a predetermined voltage,
and resistively or capacitively coupled with the first and second electric conductors (9a,9b) to allow an electric current or a current signal to flow between the first and second electric conductors,
**characterised in that** the movement region (12) is capable of moving up and down by a hinge part formed on one side of the movement region (12), and **in that** the piezoelectric layer (120) is formed between the hinge part and the conductive layer (3),

2. The micro switch of claim 1, wherein a dielectric film (3') is formed on the conductive layer (3) and the first and second electric conductors are formed a predetermined distance above the dielectric film (3').

3. The micro switch of claim 1, wherein the first and second electric conductors (9a,9b) are formed a predetermined distance above the conductive layer (3).

4. The micro switch as claimed in any one of claims 1 to 3, wherein a portion of the substrate positioned under the movement region (12), a portion of the dielectric layer (2) surrounding the movement region (12) except where the hinge part is formed, and a portion of the substrate positioned under a portion of the dielectric layer (2) surrounding the movement region (12), are selectively etched to provide an etched region for allowing the movement region to move up and down.

5. The micro switch as claimed in any one of claims 1 to 4, wherein the piezoelectric layer (120) is formed between the conductive layer (3) and a hinge part.

6. The micro switch as claimed in any one of claims 1 to 5, further comprising anchors respectively supporting the first and second electric conductors (9a,9b), signal terminals applying signals to the electric conductors (9a,9b), and piezoelectric electrode terminals (13a,13b) applying a voltage to the piezoelectric layer (120).

7. The micro switch as claimed in any one of claims 1 to 6, wherein any of the conductive layer (3), the electric conductors (9a,9b), anchors (6), signal terminals and piezoelectric electrode terminals (13a,13b) is formed of one, or a combination of more than one selected from the group consisting of Au, Ag, Cu, Pt and Rd.

## Patentansprüche

1. Mikroschalter, der Folgendes umfasst:
ein Substrat (1);
eine dielektrische Schicht (2), die auf dem Substrat ausgebildet ist, wobei die dielektrische Schicht ein Bewegungsgebiet (12) aufweist, das aus einem vorbestimmten Abschnitt der dielektrischen Schicht ausgebildet ist, der sich nach oben und unten bewegen kann;
eine leitende Schicht (3), die auf einem vorbestimmten Abschnitt der Bewegungsschicht ausgebildet ist;
einen ersten und zweiten elektrischen Leiter (9a, 9b), die über der leitenden Schicht (3) ausgebildet sind; und
eine piezoelektrische Schicht (120), die auf dem Bewegungsgebiet ausgebildet ist und bewirkt, dass sich die leitende Schicht (3) durch das Anlegen einer vorbestimmten Spannung nach oben bewegt und resistiv oder kapazitiv mit dem ersten und zweiten elektrischen Leiter (9a, 9b) gekoppelt ist, damit ein elektrischer Strom oder ein Stromsignal zwischen dem ersten und zweiten elektrischen Leiter fließen kann,
**dadurch gekennzeichnet, dass** das Bewegungsgebiet (12) durch ein auf einer Seite des Bewegungsgebiets (12) ausgebildetes Gelenkteil nach oben und unten bewegen kann und dass die piezoelektrische Schicht (120) durch das Gelenkteil und die leitende Schicht (3) gebildet wird.

2. Mikroschalter nach Anspruch 1, wobei ein dielektrischer Film (3') auf der leitenden Schicht (3) ausgebildet ist und der erste und zweite elektrische Leiter in einem vorbestimmten Abstand über dem dielektrischen Film (3') ausgebildet sind.

3. Mikroschalter nach Anspruch 1, wobei der erste und zweite elektrische Leiter (9a, 9b) in einem vorbestimmten Abstand über der leitenden Schicht (3) ausgebildet sind.

4. Mikroschalter nach einem der Ansprüche 1 bis 3, wobei ein unter dem Bewegungsgebiet (12) positionierter Abschnitt des Substrats, ein Abschnitt der dielektrischen Schicht (2), der das Bewegungsgebiet (12) außer dort umgibt, wo das Gelenkteil ausgebildet ist, und ein Abschnitt des Substrats, der unter einem Abschnitt der dielektrischen Schicht (2) positioniert ist, der das Bewegungsgebiet (12) umgibt, selektiv geätzt werden, um ein geätztes Gebiet bereitzustellen, damit sich das Bewegungsgebiet nach oben und unten bewegen kann.

5. Mikroschalter nach einem der Ansprüche 1 bis 4, wobei die piezoelektrische Schicht (120) zwischen der leitenden Schicht (3) und einem Gelenkteil ausgebildet ist.

6. Mikroschalter nach einem der Ansprüche 1 bis 5, weiterhin umfassend Anker, die jeweils den ersten und zweiten Leiter (9a, 9b) stützen, wobei Signalanschlüsse Signale an die elektrischen Leiter (9a, 9b) anlegen und piezoelektrische Elektrodenanschlüsse (13a, 13b) eine Spannung an die piezoelektrische Schicht (120) anlegen.

7. Mikroschalter nach einem der Ansprüche 1 bis 6, wobei eine beliebige der leitenden Schicht (3), der elektrischen Leiter (9a, 9b), Anker (6), Signalanschlüsse und piezoelektrischen Elektrodenanschlüsse (13a, 13b) aus einem Element oder aus einer Kombination aus mehr als einem Element ausgewählt aus der Gruppe bestehend aus Au, Ag, Cu, Pt und Rd ausgebildet ist.

## Revendications

1. Micro-commutateur comprenant :
un substrat (1) ;
une couche diélectrique (2) formée sur le substrat, la couche diélectrique ayant une zone de mouvement (12) formée d'une partie prédéterminée de la couche diélectrique qui est capable de s'élever et de s'abaisser ;
une couche conductrice (3) formée sur une partie prédéterminée de la zone de mouvement ;
un premier et un deuxième conducteurs électriques (9a, 9b) formés au-dessus de la couche conductrice (3) ; et
une couche piézo-électrique (120) formée sur la zone de mouvement, faisant que la couche conductrice (3) s'élève par l'alimentation d'une tension prédéterminée, et couplée de manière résistive ou capacitive avec les premier et deuxième conducteurs électrique (9a, 9b) pour permettre à un courant électrique ou à un signal de tension de passer entre les premier et deuxième conducteurs électriques,
**caractérisé en ce que** la zone de mouvement (12) est capable de s'élever et s'abaisser par le biais d'une partie de pivot formée sur un côté de la zone de mouvement (12) et **en ce que** la couche piézo-électrique (120) est formée entre la partie de pivot et la couche conductrice (3).

2. Micro-commutateur selon la revendication 1, dans lequel un film diélectrique (3') est formé sur la couche conductrice (3) et les premier et deuxième conducteurs sont formés à une distance prédéterminée au-dessus du film diélectrique (3').

3. Micro-commutateur selon la revendication 1, dans lequel les premier et deuxième conducteurs (9a, 9b) sont formés à une distance prédéterminée au-dessus de la couche conductrice (3).

4. Micro-commutateur selon l'une quelconque des revendications 1 à 3, dans lequel une partie du substrat positionnée sous la zone de mouvement (12), une partie de la couche diélectrique (2) entourant la zone de mouvement (12), sauf là où la partie de pivot est formée, et une partie du substrat positionnée sous une partie de la couche diélectrique (2) entourant la zone de mouvement (12) sont gravées chimiquement de manière sélective pour produire une zone gravée chimiquement afin de permettre à la zone de mouvement de s'élever et s'abaisser.

5. Micro-commutateur selon l'une quelconque des revendications 1 à 4, dans lequel la couche piézo-électrique (120) est formée entre la couche conductrice (3) et une partie de pivot.

6. Micro-commutateur selon l'une quelconque des revendications 1 à 5, comprenant en outre des ancrages soutenant respectivement les premier et deuxième conducteurs électrique (9a, 9b), des bornes de signaux appliquant des signaux aux conducteurs électriques (9a, 9b), et des bornes d'électrodes piézo-électriques (13a, 13b) appliquant une tension à la couche piézo-électrique (120).

7. Micro-commutateur selon l'une quelconque des revendications 1 à 6, dans lequel l'un quelconque de la couche conductrice (3), des conducteurs électriques (9a, 9b), des ancrages (6), des bornes de signaux et des bornes d'électrodes piézo-électriques (13a, 13b) est formé d'un élément, ou de la combinaison de plusieurs éléments, sélectionné(s) parmi le groupe constitué de Au, Ag, Cu, Pt et Rd.
